Europäisches Patentamt

European Patent Office

Office européen des brevets

(19)

(11) Veröffentlichungsnummer : **0 030 267**
**B1**

(12) **EUROPÄISCHE PATENTSCHRIFT**

(45) Veröffentlichungstag der Patentschrift :
09.03.83

(21) Anmeldenummer : 80106594.7

(22) Anmeldetag : 27.10.80

(51) Int. Cl.³ : **H 01 R 4/02, B 23 K 26/00,
H 05 K 3/34, H 01 R 4/14**

(54) Verfahren zur Ankontaktierung von dünnen elektrischen Leitungsdrähten.

(30) Priorität : **19.11.79 DE 2946626**

(43) Veröffentlichungstag der Anmeldung :
**17.06.81 Patentblatt 81/24**

(45) Bekanntmachung des Hinweises auf die Patenterteilung : **09.03.83 Patentblatt 83/10**

(84) Benannte Vertragsstaaten :
**AT BE FR GB IT NL**

(56) Entgegenhaltungen :
**DE A 2 737 573
US A 3 610 874**

(73) Patentinhaber : **Telefonbau und Normalzeit GmbH
Mainzer Landstrasse 128-146 Postfach 4432
D-6000 Frankfurt (Main) (DE)**

(72) Erfinder : **Maul, Hans
Sonnensteig 1
D-6369 Schöneck (DE)**

Jouve, 18, rue St-Denis, 75001 Paris, France

## Verfahren zur Ankontaktierung von dünnen elektrischen Leitungsdrähten

Die Erfindung betrifft ein Verfahren zur Ankontaktierung von dünnen elektrischen Leitungsdrähten, wobei die Enden der Drähte um Anschlußpfosten gewickelt werden, die senkrecht oder schräg auf einer Trägerplatte stehen.

Es ist bekannt, die Drahtenden bei mit Wicklungen versehenen elektrischen Bauteilen wie Transformatoren und Spulen aller Art zum Zwecke der Befestigung um Anschlußpfosten zu wickeln. Meist werden diese Drähte zur besseren Kontaktgabe noch verlötet oder verschweißt. Die Anschlußpfosten dienen dann zur Verbindung des Bauteiles mit der übrigen Schaltungsanordnung. Beim Löten muß, damit überhaupt ein Kontakt herstellbar ist, die Isolation entfernt werden. Dies kann auch durch die Wärmeeinwirkung beim Löten selbst geschehen, indem durch die Hitze eine Lackisolation weggebrannt wird. In vielen Fällen ist jedoch eine vorherige Entfernung der Isolation notwendig.

Bei sehr dünnen Drähten ist das Entfernen der Isolation problematisch, weil der Draht sowohl durch mechanische Beanspruchung als auch durch Hitzeeinwirkung beschädigt werden kann, und es dann leicht zu Drahtbrüchen kommt. Dieses Problem tritt auch bei der beim Schweißen auftretenden größeren Hitze, die zum Verschmelzen der Materialien führen soll, auf. Selbst bei genauer Dosierung der Hitze, wie dies beispielsweise bei der Anwendung eines Laserstrahles für das Schweißen möglich ist, wird ein sehr dünner Draht weggebrannt, bevor er mit dem Material des Anschlußpfostens verschmelzen kann.

Deshalb ist es Aufgabe der Erfindung, ein Verfahren anzugeben, mit dem das Ankontaktieren von dünnen Leitungsdrähten auf wirtschaftliche Weise sicher ausgeführt werden kann.

Die Lösung der Aufgabe erfolgt dadurch, daß ein Anschlußpfosten nach dem Umwickeln des Drahtendes so umgebogen wird, daß die Drahtwindungen in dem Knick zu liegen kommen, und daß anschließend der umgebogene Anschlußpfosten mit einem den Leitungsdraht nicht direkt berührenden Laserstrahl so beschickt wird, daß das Material des Anschlußpfostens mit dem Leitungsdraht verschmilzt.

Mit diesem Verfahren wird in vorteilhafter Weise erreicht, daß ein Verschmelzvorgang stattfindet und der Draht dabei nicht beschädigt wird. Gemäß den Weiterbildungen der Erfindung entsteht kein zusätzlicher Aufwand, weil die Anschlußpfosten Bestandteile gestanzter oder gedruckter Schaltungen sind und die Isolation des Drahtes nicht entfernt werden muß. Außerdem ist mit diesem Verfahren ein automatisch ablaufender Herstellprozess möglich.

Nachfolgend wird ein Beispiel für die Durchführung des Verfahrens anhand von Zeichnungen näher erläutert. Es zeigt :

Figur 1a die Seitenansicht einer Trägerplatte mit um Anschlußpfosten AP gewickelte Drahtenden D,

Figur 1b die Draufsicht dieser Anordnung,

Figur 2 die Seitenansicht, nach dem die Anschlußpfosten AP umgebogen sind und das Auftreffen des Laserstrahles L.

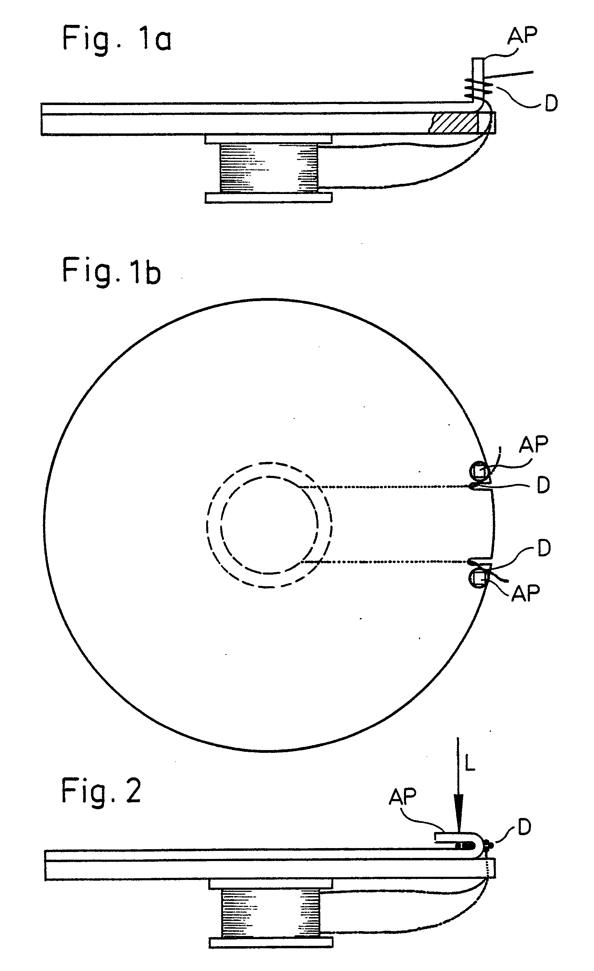

In der Fig. 1a ist gezeigt, wie die Drahtenden D einer Spule, in diesem Beispiel für ein dynamisches Mikrofon, um Anschlußpfosten AP gewickelt sind. Diese Anschlußpfosten AP können als Teil einer gestanzten Schaltung aus der Ebene der Trägerplatte herausragen. Sie können aber auch in die gedruckte Schaltung einer Leiterplatte eingelötet oder eingeschweißt sein. Zur Verdeutlichung der Anordnung ist in Fig. 1b die Draufsicht gezeichnet.

Nachdem die Umwicklung der Anschlußpfosten AP mit den Drahtenden stattgefunden hat, werden die Anschlußpfosten wie in Fig. 2 gezeigt zur Trägerplatte hin umgebogen. Dabei kommen die Drahtwindungen in dem Knick zu liegen und werden dort arretiert. Im nächsten Arbeitsgang wird ein Laserstrahl, wie im Bild durch einen Pfeil angedeutet, auf den umgebogenen Pfosten gebracht. Dabei verschmelzen die Drahtwindungen mit dem Anschlußpfosten, und es ist ein elektrisch einwandfreier Kontakt innerhalb kürzester Zeit hergestellt.

Die hier beschriebenen Verfahrensschritte können nacheinander durch eine oder mehrere automatisch arbeitende Maschinen ausgeführt werden. Es ist dabei ein für die Mengenfertigung bedeutungsvoller rationeller Herstellprozess gegeben.

**Ansprüche**

1. Verfahren zur Ankontaktierung von dünnen elektrischen Leitungsdrähten, wobei die Enden der Drähte um Anschlußpfosten (AP) gewickelt werden, die senkrecht oder schräg auf einer Trägerplatte stehen, dadurch gekennzeichnet, daß ein Anschlußpfosten (AP) nach dem Umwickeln des Drahtendes (D) so umgebogen wird, daß die Drahtwindungen in dem Knick zu liegen kommen, und daß anschließend der umgebogene Anschlußpfosten (AP) mit einem den Leitungsdraht nicht direkt berührenden Laserstrahl (L) so beschickt wird, daß das Material des Anschlußpfostens (AP) mit dem Leitungsdraht verschmilzt.

2. Verfahren nach Anspruch 1, dadurch gekennzeichnet, daß die Leitungsdrähte mit der Isolation (beispielsweise Lack) um die Anschlußpfosten (AP) gewickelt werden, und daß die Isolation beim Ankontaktiervorgang verdampft.

3. Verfahren nach Anspruch 1, dadurch gekennzeichnet, daß der Anschlußpfosten (AP) Teil einer gestanzten Schaltung ist oder mit einer gedruckten Schaltung verbunden ist.

4. Verfahren nach einem der Ansprüche 1 bis 3, dadurch gekennzeichnet, daß das Verfahren durch automatisch gesteuerte Maschinen selbsttätig in aufeinanderfolgenden Schritten durchgeführt wird.

## Claims

1. Method of making contact with small electrically contacting wires, whereby the ends of the wires are wrapped around connection pins which are standing vertically or diagonally upon a carrier board, comprising that a connection pin (AP) is bent to a hook after wrapping the end of the wire (D) such that the windings of the wire are placed into the hook, and after that a laser beam (L) is applied to the hooked connection pin (AP) which does not touch the conducting wire directly thus fusioning the material of the connection pin (AP) with the conducting wire.

2. Method as claimed in Claim 1 comprising that the conducting wires are wrapped around the connection pin (AP) with their insulation (for example varnish) and that the insulation is evaporated during the contact making process.

3. Method as claimed in Claim 1, comprising that the connection pin (AP) is a part of a stamped circuit or is linked to a printed circuit.

4. Method as claimed in one of the Claims 1 to 3, comprising that the method is practised automatically in succeeding steps by automatically controlled machines.

## Revendications

1. Procédé de raccordement de fils conducteurs électriques fins, dans lequel les extrémités des fils sont enroulées autour de pions de connexion (AP), placés verticalement ou obliquement sur une plaque-support, caractérisé en ce que, après avoir enroulé l'extrémité (D) du fil autour d'un pion de connexion (AP), ce dernier est courbé de telle façon que les spires du fil se trouvent à l'intérieur du coude ainsi formé, et en ce que, ensuite, le pion de connexion (AP) courbé est attaqué par un faisceau laser (L) qui ne touche pas directement le fil conducteur, de telle façon que la matière du pion de connexion (AP) fusionne avec le fil conducteur.

2. Procédé selon la revendication 1, caractérisé en ce que les fils conducteurs sont enroulés autour des pions de connexion (AP) avec leur isolation (par exemple du vernis) et que cette isolation se vaporise lors de l'opération de réalisation du raccordement.

3. Procédé selon la revendication 1, caractérisé en ce que le pion de raccordement (AP) fait partie d'un circuit découpé à la presse ou est relié à un circuit imprimé.

4. Procédé selon l'une quelconque des revendications 1 à 3, caractérisé en ce qu'il est exécuté automatiquement, par des machines à commande automatique, par étapes successives.

# Fig. 1a

AP

D

# Fig. 1b

AP

D

D

AP

# Fig. 2

AP

L

D